# EUROPÄISCHE PATENTSCHRIFT

(11) **EP 2 802 766 B1**
(45) Veröffentlichungstag und Bekanntmachung des Hinweises auf die Patenterteilung: **15.09.2021**
(21) Anmeldenummer: 13700162.4
(22) Anmeldetag: 10.01.2013
(51) Int. Cl.: H01L 41/053, H01L 41/083

(54) **AKTORMODUL MIT EINEM IN EINEM GEHÄUSE ANGEORDNETEN VIELSCHICHTAKTOR UND KONSTANT EXTREM NIEDRIGEN LECKSTROM AN DER AKTOROBERFLÄCHE**
ACTUATOR MODULE HAVING A MULTI-LAYER ACTUATOR ARRANGED IN A HOUSING AND A CONTINUOUSLY EXTREMELY LOW LEAKAGE CURRENT AT THE ACTUATOR SURFACE
MODULE D'ACTIONNEMENT MUNI D'UN ACTIONNEUR MULTICOUCHE AGENCÉ DANS UN BOÎTIER ET PRÉSENTANT UN COURANT DE FUITE EXTRÊMEMENT BAS CONSTANT AU NIVEAU DE LA SURFACE DE L'ACTIONNEUR

(30) Priorität: 11.01.2012 DE 102012200328
(43) Veröffentlichungstag der Anmeldung: 19.11.2014
(60) Teilanmeldung: 15185506.1
(73) Patentinhaber: CeramTec GmbH, 73207 Plochingen (DE)
(72) Erfinder: BINDIG, Reiner, 95463 Bindlach (DE); SCHREINER, Hans-Jürgen, 91217 Hersbruck (DE)
(74) Vertreter: Fehrenbacher, Eckhard Anton
(86) Internationale Anmeldenummer: PCT/EP2013/050393
(87) Internationale Veröffentlichungsnummer: WO 2013/104710

(56) Entgegenhaltungen:
- DE-A1- 10 211 107
- DE-A1- 19 753 930
- US-A- 5 239 223
- US-A1- 2003 107 301
- US-A1- 2004 242 746
- US-A1- 2006 148 920
- US-A1- 2009 154 053

## Beschreibung

Die Erfindung betrifft ein Aktormodul mit einem in einem Gehäuse angeordneten piezokeramischen Vielschichtaktor.

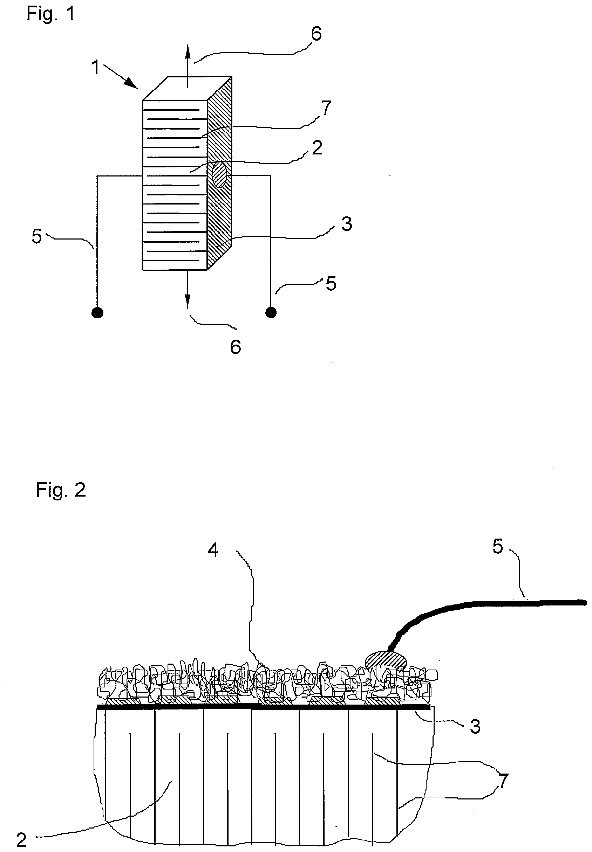

Bekannte piezokeramische Vielschichtaktoren 1 (siehe Figur 1) bestehen aus gestapelten dünnen Schichten piezoelektrisch aktiven Materials 2, z. B. Blei-Zirkonat-Titanat (PZT), mit dazwischen angeordneten leitfähigen Innenelektroden 7, die z. B. alternierend an die Aktoroberfläche geführt werden. Eine Grundmetallisierung 3 verbindet diese Innenelektroden 7. Dadurch werden die Innenelektroden 7 elektrisch parallel geschaltet und zu zwei Gruppen zusammengefasst, welche die beiden Anschlüsse 5 des Vielschichtaktors 1 darstellen. Legt man eine elektrische Spannung an die Anschlüsse 5, so wird diese auf alle Innenelektroden 7 parallel übertragen und verursacht ein elektrisches Feld in allen Schichten aktiven Materials 2, das sich dadurch mechanisch verformt. Die Summe aller dieser mechanischen Verformungen steht an den Endflächen des Aktors als nutzbare Dehnung 6 und/oder Kraft zur Verfügung.

Piezokeramische Vielschichtaktoren werden nach dem Stand der Technik als Monolithen ausgeführt, d. h. das aktive Material wird vor dem Sintern als sogenannte Grün-Folie durch ein Siebdruckverfahren mittels Edelmetallpaste mit Innenelektroden versehen, zu Aktorstapeln verpresst, pyrolysiert und dann gesintert, wodurch der monolithische Aktor entsteht.

Die Oberflächen des Aktorkörpers werden nun durch ein formgebendes Verfahren, im Allgemeinen durch Schleifen bearbeitet. Auf den Aktor (siehe Figur 2) wird im Bereich der herausgeführten Innenelektroden 7 z. B. durch galvanische Verfahren oder Siebdruck von Metallpaste eine Grundmetallisierung 3 aufgebracht. Diese Grundmetallisierung 3 wird verstärkt durch Aufbringen einer metallischen Außenelektrode 4 z. B. ein strukturiertes Blech, ein Drahtnetz oder Drahtgewebe. An diese Außenelektrode 4 wird der elektrische Anschluss 5 gelötet. Vor oder nach dem Anlöten der Anschlüsse 5 wird der Aktor mit einer elektrisch isolierenden Beschichtung überzogen, die zudem vor mechanischer Verletzung der Aktoroberflächen schützt.

Figur 1 zeigt einen piezokeramischen Vielschichtaktor nach dem Stand der Technik und Figur 2 zeigt als Verbesserung eine Außenelektrode 4 zwischen der Grundmetallisierung 3 und den Anschlüssen 5.

Der Aufbau und die Herstellung derartiger Aktoren und Außenelektroden wird ausführlich beschrieben z. B. in EP 0 844 678 B1, DE 33 30 538 A1, DE 40 36 287 C2, US 5 281 885, US 4 845 399, US 5 406 164 und JP 07-226541 A.

Viele Anwendungen für Vielschichtaktoren (nachfolgend auch allgemein als Aktoren bezeichnet) stellen die Forderung, dass der Aktor über lange Zeiträume mit der Nennspannung beaufschlagt werden kann, ohne dass er seine Eigenschaften ändert. Typisch Anwendungen sind Stell- und Positionierantriebe, die eine bestimmte Position anfahren, und unter Umständen über Monate und Jahre halten müssen. Diese Anforderung kann mit Aktoren nach dem oben beschriebenen Stand der Technik nicht erfüllt werden.

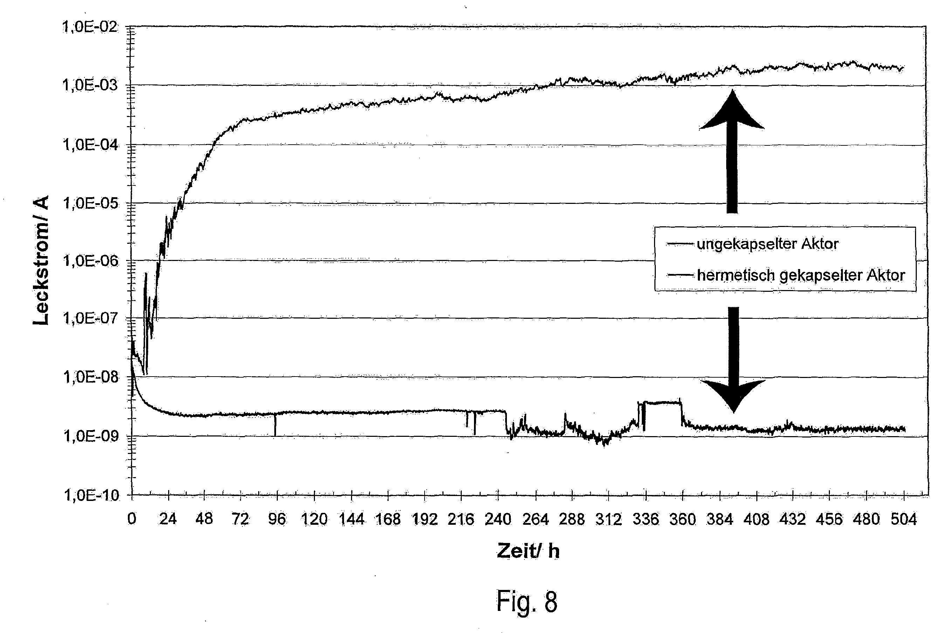

Ursache hierfür ist, dass durch die hohe elektrische Feldstärke an der Aktoroberfläche polare Moleküle, gewöhnlich Wasserdampf, aus der Umgebung angezogen werden. Dieser Wasserdampf durchdringt alle bekannten polymeren Umhüllungen mehr oder weniger schnell und führt schließlich an der Aktoroberfläche zu erhöhter Leitfähigkeit und zu ansteigendem Leckstrom. Der Leckstrom steigt so lange an bis sich durch die ebenfalls ansteigende Aktortemperatur ein Gleichgewicht für Wasserdampfadsorption durch das elektrische Feld und Desorption durch die Aktortemperatur einstellt. Den typischen Leckstromverlauf über der Zeit für einen Aktor mit den Abmessungen 7 × 7 × 30 mm³ bei einer inneren Feldstärke von 2000 V/mm unter normalen Laborumgebungsbedingungen zeigt das Diagramm in Figur 8.

Verwendet man als Überzug keramische Beschichtungen oder Gläser, so dringt der Wasserdampf durch Mikrorisse der Beschichtung, die sich zwangsläufig durch den Betrieb des Aktors bilden.

Auch das Umgießen mit einer geeigneten Vergussmasse in einem Metallgehäuse führt nicht zum Erfolg, da bereits die äußerst geringen Wassermengen die in der Vergussmasse enthalten sind, oder die während des Verkapselungsschrittes eindringen, genügen, den Effekt auszulösen.

Schwachpunkte bilden die immer notwendigen Dehnungsfugen an Boden und Deckel der Gehäuse, durch die Feuchtigkeit eindringt und die Anschlüsse bzw. Anschlussdrähte, die durch die Beschichtung beziehungsweise das Gehäuse nach außen geführt werden müssen. Die Verwendung von mit Kunststoffen isolierten Drähten führt aus oben genannten Gründen nicht zum Ziel.

US 5,239,223, als nächstliegender Stand der Technik, zeigt ein Aktormodul mit einem in einem Gehäuse angeordneten piezokeramischen Vielschichtaktor, wobei das Gehäuse hermetisch verschlossen ist und zwischen dem Vielschichtaktor und dem Gehäuse ein Raum angeordnet ist und das Gehäuse aus einem Gehäusedeckel, einem Gehäusemantel und einem Gehäuseboden besteht und in das Gehäuse elektrische Anschlüsse für den Vielschichtaktor geführt sind.

Der Erfindung liegt die Aufgabe zugrunde, ein derartiges Aktormodul mit einem in einem Gehäuse angeordneten piezokeramischen Vielschichtaktor so zu verbessern, dass es an der Aktoroberfläche auch nach langer Betriebsdauer zu keiner erhöhten Leitfähigkeit und damit ansteigendem Leckstrom kommt.

Erfindungsgemäß wird diese Aufgabe durch die Merkmale des Anspruchs 1 gelöst.

Dadurch, dass das Gehäuse durch Verschweißen, insbesondere Laserschweißen, Hartlöten mit Metallot, Löten mit Glaslot oder Weichlöten hermetisch verschlossen ist, der Raum mit einem Medium teilgefüllt oder gefüllt ist, das Medium Wasser beim Aushärten aufnimmt und chemisch umwandelt und der Gehäuseboden aus Metall besteht und die elektrischen Anschlüsse über eine Glasdurchführung oder Keramikdurchführung im Gehäuseboden in das Innere des Gehäuses geführt sind oder der Gehäuseboden aus Keramik besteht und metallisierte Durchbrüche aufweist in die die elektrischen Anschlüsse eingelötet sind, kann eindringender Wasserdampf zu keiner erhöhten Leitfähigkeit und damit ansteigendem Leckstrom an der Aktoroberfläche führen. Mit dem Begriff Wasser wird auch Wasserdampf verstanden.

US 2009/0154053 A1 scheint sich auf einschichtige kapazitive Elemente, also beispielsweise Kondensatoren zu beziehen. Es werden jedoch auch "EAP film layers for operation as a actuator" beschrieben. Insofern scheint diese Druckschrift auch Vielschichtaktoren zu beschreiben. Der Fachmann kann dieser Druckschrift Materialien entnehmen, die bei der gewünschten chemischen Reaktion neben CO₂ auch Wasser bilden.

Durch das hermetisch verschlossene Gehäuse gelangt nur sehr wenig Wasser bzw. Wasserdampf in das Innere des Gehäuses und diese geringe Menge wird dann vom Medium umgewandelt oder gebunden und kann sich nicht auf der Aktoroberfläche absetzen.

Es gibt verschiedene Medien die geignet sind. In einer Auführungsform verbraucht das Medium Wasser reaktiv. Bevorzugt enthält das Medium Polyurethanharz.

In das Gehäuse sind elektrische Anschlüsse für den Vielschichtaktor geführt. Das Gehäuse besteht aus einem Gehäusedeckel, einem Gehäusemantel und einem Gehäuseboden. Die elektrischen Anschlüsse sind hermetisch und elektrisch isolierend in den Gehäuseboden integriert.

Dies geschieht in einer Ausgestaltung dadurch, dass der Gehäuseboden aus Metall besteht und die elektrischen Anschlüsse über eine Glasdurchführung oder Keramikdurchführung im Gehäuseboden in das Innere des Gehäuses geführt sind. Glasdurchführungen sind luftdicht und wasserdicht auszuführen.

Alternativ besteht der Gehäuseboden aus Keramik und weist metallisierte Durchbrüche auf in die die elektrischen Anschlüsse eingelötet sind. Bevorzugt weist der Gehäuseboden einen metallisierten Bereich am Außenumfang auf, über den eine hermetisch dichte Verbindung des Gehäusebodens mit dem Gehäusemantel erfolgt.

In einer Ausführungsform besteht der Gehäusedeckel aus Keramik und weist bevorzugt einen metallisierten Bereich am Außenumfang auf, über den eine hermetisch dichte Verbindung des Gehäusedeckels mit dem Gehäusemantel erfolgt.

Damit der Aktor sich ungehindert ausdehnen kann und dies zu keinen Schäden am Gehäuse führt, besteht der Gehäusemantel in einer bevorzugten Ausführungsform ganz oder teilweise aus einem Metallbalg.

Bevorzugt erzeugt der ganz oder teilweise aus einem Metallbalg bestehende Gehäusemantel die erforderliche mechanische Vorspannung für den Vielschichtaktor.

In einer Ausführungsform besteht der Gehäusemantel ganz oder teilweise aus Keramik und die elektrischen Anschlüsse sind im Gehäuseboden angeordnet.

Der Gehäuseboden und/oder der Gehäusedeckel kann auch aus einer biegsamen Membran bestehen. In diesem Fall kann auf einen Metallbalg verzichtet werden.

Der Gehäuseboden, der Gehäusemantel und der Gehäusedeckel werden durch Verschweißen, insbesondere Laserschweißen, Hartlöten mit Metallot, Löten mit Glaslot oder Weichlöten hermetisch dicht verbunden.

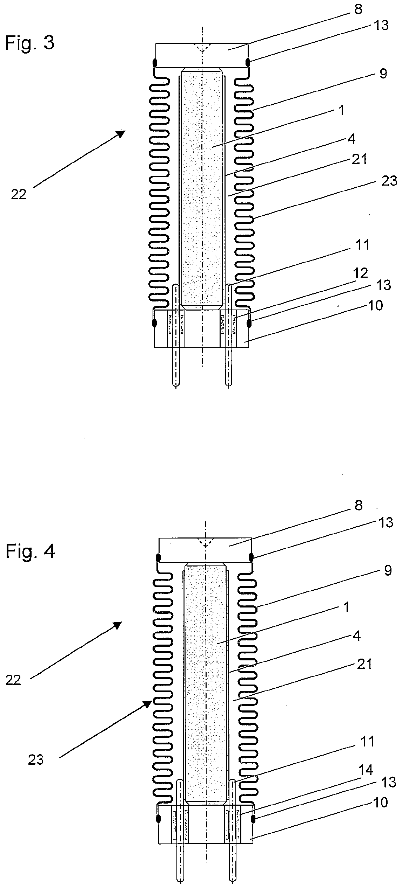

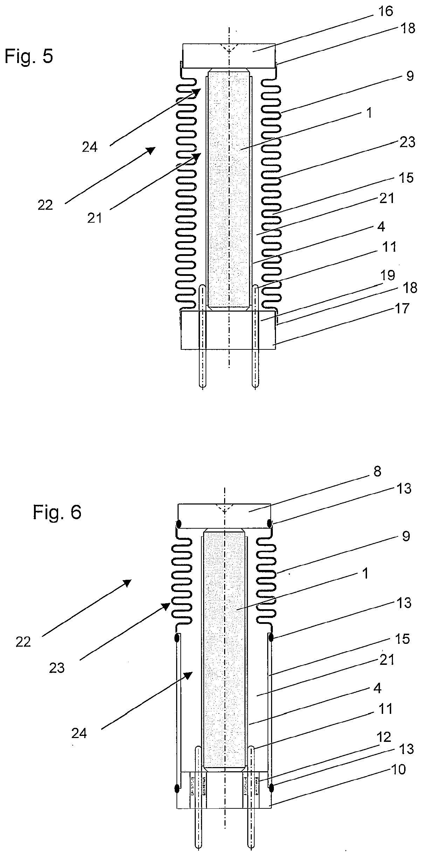

Nachfolgend wird die Erfindung anhand der Figuren 3 bis 6 weiter erläutert.

Mit Aktormodul wird die Einheit aus Aktor 1 und Gehäuse verstanden.

Es wird vorgeschlagen, piezokeramische Aktoren 1 in ein metallisches oder keramisches Gehäuse 23 einzubauen, bei dem die Anschlüsse 11 integrale Bestandteile des Gehäusebodens 10, 17 sind. Die Anschlüsse können beispielsweise mittels Glasdurchführungen 12 gasdicht gegen die Umgebung abgedichtet sein. Das Gehäuse 23 ist beispielsweise mittels Verschweißung 13 hermetisch dicht verschlossen. Die Gehäuseform ist so gewählt, dass eine kleine mechanische Vorspannung auf den Aktor 1 ausgeübt wird um ihn in Position zu halten. Das Gehäuse 23 muss zumindest teilweise nachgiebig sein, damit es dem Hub des Aktors 1 keinen zu großen Widerstand entgegensetzt. Das erreicht man, indem man das Gehäuse 23, bzw. den Gehäusemantel 9 als Metallbalg ausführt oder das Gehäuse 23 mit einer Metallmembran abschließt. Die Steifigkeit des Gehäuses ist vorzugsweise klein gegenüber der Aktorsteifigkeit.

In das Gehäuse 23 wird ein Medium 21 gegeben, das die beim Verbau eingeschlossenen Wassermoleküle chemisch umwandelt. Für die Entstehung der Leckströme sind extrem kleine Wassermengen, wie sie typischerweise an Oberflächen adsorbiert sind, ausreichend. Daher ist es notwendig, diese kleinsten Wassermengen zu deaktivieren und das Gehäuse 23 durch Löten mit Metall oder Glas 18, 19 oder durch Schweißen 13 hermetisch dicht zu verschließen.

Dies führt zu folgenden Vorteilen:

Derartig hermetisch gekapselte Aktormodule 22 zeigen konstant extrem niedrige Leckströme, auch wenn sie permanent mit der Nennfeldstärke betrieben werden. Figur 8 zeigt als Diagramm den Leckstromverlauf an einem derart gekapselten Aktor 1. Aktorabmessungen und sonstige Parameter entsprechen dem ungekapselten Aktor gemäß Figur 8. Der Leckstrom des gekapselten Aktors 1 ist etwa 1.000.000 mal kleiner als der des ungekapselten Aktors.

Beim Herstellen des Aktors 1 wird eine niedrig sinternde Piezokeramik, z. B. nach DE 198 40 488 A1 mit einem organischen Bindersystem als 125 µm dicke Folie präpariert. Auf diese Folie wird eine handelsübliche Innenelektrodenpaste mittels Siebdruck aufgebracht. Eine Vielzahl derartiger Folien wird gestapelt und zu einem Laminat verpresst, wobei an Ober- und/oder Unterseite des Laminates einige Folien ohne Innenelektroden 7 bleiben, um einen inaktiven Bereich zu erzeugen, an dem der Aktor 1 später elektrisch kontaktiert werden kann. Das Laminat wird zu einzelnen, stabförmigen Aktoren zertrennt, diese werden bei 900 °C - 1100 °C, vorzugsweise bei 1000 °C gesintert. Nach dem Schleifen der Aktoroberflächen wird die Grundmetallisierung 3 aus Silber mittels eines Siebdruck/Einbrennprozesses auf die Kontaktseiten aufgebracht. Die Außenelektroden 4 aus Metalldraht-Netz werden darauf aufgelötet. Zum Schutz vor mechanischer Beschädigung und zur elektrischen Isolation bei den folgenden Messvorgängen werden die Aktoren 1 nun mit einem handelsüblichen Silikonlack isoliert. Die Aktoren 1 können nun polarisiert und elektrisch gemessen werden.

Ein Aktorgehäuse 23 wird hergestellt indem ein Metallbalg als Gehäusemantel 9 verwendet wird, der etwas kürzer ist als der Aktor 1. Beiderseits sind am Gehäusemantel 9 Bereiche vorgesehen, die das Anschweißen eines Gehäusedeckels 8 ermöglichen. Der Innendurchmesser des Gehäusemantels 9 bzw. des Metallbalgs ist derart, dass der Aktor 1 die Wandung des Gehäusemantels 9 nicht berührt, wenn er in den Metallbalg eingefügt wird.

Ein Gehäuseboden 10, 17 für das Gehäuse 23 wird hergestellt, indem in eine planparallele Metallscheibe zwei Bohrungen eingebracht werden. In diese Bohrungen werden beispielsweise durch Glaslot hermetisch dicht und elektrisch isolierend, Anschlussstifte als Anschlüsse 11 eingebracht. Es handelt sich um eine Glasdurchführung 12.

Als Gehäusedeckel 8 dient eine planparallele Metallscheibe ohne Bohrungen.

Der Aktor 1 wird nun auf dem Gehäuseboden 10, 17 mittels eines Epoxid- Klebstoffs so fixiert, dass er mit seinen Außenelektroden 4 mit den beiden Kontaktstiften als Anschlüsse 11 in Berührung kommt. Der Kontakt zwischen Außenelektrode 4 und den Kontaktstiften wird mittels Löten, Schweißen oder Kleben mit leitfähigem Kleber hergestellt.

Das Aktorgehäuse 23 wird über den Aktor 1 gesteckt, und mit dem Gehäuseboden 10, 17 z.B. mit einem Laser verschweißt. Der Aktor 1 ragt nun etwas über den Metallbalg als Gehäusemantel 9 hinaus. Er darf bei diesem Vorgang das Gehäuse 23 nicht berühren.

Der Zwischenraum bzw. Raum 24 zwischen Aktor 1 und Aktorgehäuse wird nun mit einem wasserverbrauchenden Medium 21 gefüllt, z.B. mit einem Polyurethanharz, das beim Aushärten Wasser aufnimmt und chemisch umwandelt und dabei beispielsweise CO₂ freisetzt.

Der Gehäusedeckel 8 wird nun auf den Aktor 1 gesetzt, das Gehäuse 9 wird an den Deckel 8 gezogen und z.B. mit Laserschweißen hermetisch dicht befestigt.

Die oben beschriebene Vorgehensweise bei der Herstellung monolithischer Vielschichtaktoren ist, wie in der Einführung beschrieben, in der Patentliteratur und sonstigen Veröffentlichungen ausführlich diskutiert. Das erfindungsgemäße Vorgehen bei der Kapselung der Aktoren muss nicht dem beschriebenen Arbeitsablauf entsprechen. Es sind für den Fachmann auch ähnliche Vorgehensweisen ableitbar, die zum gleichen Ergebnis führen.

Mit dem Begriff hermetisch wird luftdicht und wasserdicht verstanden.

### Zeichnungen:

Fig. 1: Aufbau eines monolithischen Vielschichtaktors
Fig. 2: Detailansicht von Fig.1
Fig. 3: Hermetisch dichtes Gehäuse 23 mit Metallbalg als Gehäusemantel 9, Gehäusedeckel 8, Gehäuseboden 10 mit Kontaktstiften als Anschlüsse 11 in Glasdurchführungen 12. Das Gehäuse 23 ist verschweißt 13. Gehäusedeckel 8, Gehäusemantel 9 und Gehäuseboden 10 bestehen aus Metall.
Fig. 4: Hermetisch dichtes Gehäuse 23 mit Metallbalg als Gehäusemantel 9, Gehäusedeckel 8, Gehäuseboden 10 mit Kontaktstiften als Anschlüsse 11 in verlöteten Keramikdurchführungen 14. Das Gehäuse ist verschweißt 13.
Fig. 5: Hermetisch dichtes Gehäuse mit Metallbalg als Gehäusemantel 9, Keramikdeckel als Gehäusedeckel 16 mit Metallisierung am Umfang, Keramikboden als Gehäuseboden 17 mit Metallisierung am Umfang und eingelöteten Kontaktstiften als Anschlüsse 11. Das Gehäuse ist verlötet 18.
Fig. 6: Hermetisch dichtes Gehäuse mit zweiteiligem Gehäusemantel 9 aus Metallbalg und Metallrohr 15, die miteinander verschweißt sind, Gehäusedeckel 8 aus Metall, Gehäuseboden 10 aus Metall und mit Kontaktstiften als Anschlüsse 11 in Glasdurchführungen 12. Das Gehäuse ist verschweißt 13.

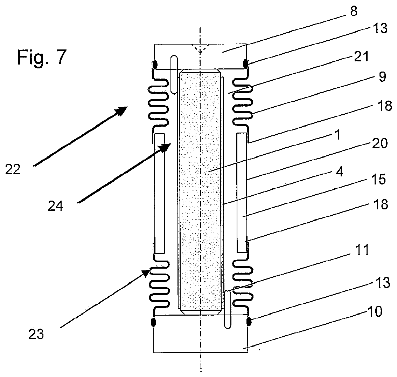

Fig. 7: Hermetisch dichtes Gehäuse mit dreiteiligem Gehäusemantel 9 aus zwei Metallbälgen die an ein teilweise metallisiertes Keramikrohr 20 gelötet sind, Gehäusedeckel 8 aus Metall und Gehäuseboden 10 aus Metall. Die Kontaktstifte als Anschlüsse 11 sind direkt mit den Außenelektroden 4 des Aktors 1 verbunden. Das Gehäuse ist verschweißt 13.
Figur 8: Leckstromverhalten eines Aktors 1 nach dem Stand der Technik ohne Gehäuse und Leckstromverhalten eines erfindungsgemäß gekapselten Aktors 1 als Aktormodul 22.

Bedeutung der einzelnen Bezeichnungen:
- 1:: monolithischer piezokeramischer Vielschichtaktor
- 2:: piezoelektrisch aktives Material
- 3:: Grundmetallisierung
- 4:: Außenelektrode
- 5:: Anschlussdrähte für die Versorgungsspannung
- 6:: Bewegungsrichtung des Aktors im Betrieb
- 7:: Innenelektroden
- 8:: Gehäusedeckel, Scheibe aus Metall
- 9:: Gehäusemantel, Metallbalg
- 10:: Gehäuseboden, Scheibe aus Metall mit Bohrungen
- 11:: Anschlüsse, Kontaktstifte aus Metall
- 12:: Glasdurchführung aus Glaslot
- 13:: Verschweißung, Schweißnaht
- 14:: Keramikdurchführung, metallisiertes Keramikröhrchen, mit Gehäuseboden und Kontaktstift verlötet
- 15:: Metallrohr
- 16:: Gehäusedeckel, Keramikscheibe, am Umfang metallisiert
- 17:: Gehäuseboden, Keramikscheibe mit innen metallisierten Bohrungen, am Umfang metallisiert
- 18:: Lötungen Metallbalg- Boden, Metallbalg- Deckel oder Metallbalg- Keramikrohr
- 19:: Lötungen Kontaktstift- Boden
- 20:: Keramikrohr, an beiden Enden am Umfang metallisiert
- 21:: wasserbindendes oder -umwandelndes Medium als Füllung

## Patentansprüche

1. Aktormodul (22) mit einem in einem Gehäuse (23) angeordneten piezokeramischen Vielschichtaktor (1), wobei das Gehäuse (23) hermetisch verschlossen ist und zwischen dem Vielschichtaktor (1) und dem Gehäuse (23) ein Raum (24) angeordnet ist und das Gehäuse (23) aus einem Gehäusedeckel (8), einem Gehäusemantel (9) und einem Gehäuseboden (10, 17) besteht und in das Gehäuse (23) elektrische Anschlüsse (11) für den Vielschichtaktor (1) geführt sind, **dadurch gekennzeichnet, dass** das Gehäuse (23) durch Verschweißen, insbesondere Laserschweißen, Hartlöten mit Metallot, Löten mit Glaslot oder Weichlöten hermetisch verschlossen ist, der Raum (24) mit einem Medium (21) teilgefüllt oder gefüllt ist, das Medium (21) Wasser beim Aushärten aufnimmt und chemisch umwandelt und der Gehäuseboden (10, 17) aus Metall besteht und die elektrischen Anschlüsse (11) über eine Glasdurchführung (12) oder Keramikdurchführung (14) im Gehäuseboden (10, 17) in das Innere des Gehäuses (23) geführt sind oder der Gehäuseboden (10, 17) aus Keramik besteht und metallisierte Durchbrüche aufweist in die die elektrischen Anschlüsse eingelötet sind.

2. Aktormodul nach Anspruch 1, **dadurch gekennzeichnet, dass** das Medium (21) Wasser reaktiv verbraucht.

3. Aktormodul nach Anspruch 1 oder 2, **dadurch gekennzeichnet, dass** das Medium (21) Polyurethanharz enthält.

4. Aktormodul nach einem der vorhergehenden Ansprüche, **dadurch gekennzeichnet, dass** der Gehäuseboden einen metallisierten Bereich am Außenumfang aufweist, über den eine hermetisch dichte Verbindung des Gehäusebodens mit dem Gehäusemantel erfolgt.

5. Aktormodul nach einem der vorhergehenden Ansprüche, **dadurch gekennzeichnet, dass** der Gehäusedeckel aus Keramik besteht und bevorzugt einen metallisierten Bereich am Außenumfang aufweist, über den eine hermetisch dichte Verbindung des Gehäusedeckels mit dem Gehäusemantel erfolgt.

6. Aktormodul nach einem der vorhergehenden Ansprüche, **dadurch gekennzeichnet, dass** der Gehäusemantel ganz oder teilweise aus einem Metallbalg besteht.

7. Aktormodul nach einem der vorhergehenden Ansprüche, **dadurch gekennzeichnet, dass** der ganz oder teilweise aus einem Metallbalg bestehende Gehäusemantel die erforderliche mechanische Vorspannung für den Vielschichtaktor erzeugt.

8. Aktormodul nach einem der vorhergehenden Ansprüche, **dadurch gekennzeichnet, dass** der Gehäusemantel ganz oder teilweise aus Keramik besteht und die elektrischen Anschlüsse im Gehäuseboden und Gehäusedeckel angeordnet sind.

9. Aktormodul nach einem der vorhergehenden Ansprüche, **dadurch gekennzeichnet, dass** der Gehäuseboden und/oder der Gehäusedeckel aus einer biegsamen Membran bestehen.

10. Aktormodul nach einem der vorhergehenden Ansprüche, **dadurch gekennzeichnet, dass** der Gehäuseboden, der Gehäusemantel und der Gehäusedeckel durch Verschweißen, insbesondere Laserschweißen, Hartlöten mit Metallot, Löten mit Glaslot oder Weichlöten hermetisch dicht verbunden werden.

## Claims

1. Actuator module (22) comprising a piezoceramic multilayer actuator (1) arranged in a housing (23), the housing (23) being hermetically sealed and a chamber (24) being arranged between the multilayer actuator (1) and the housing (23), and the housing (23) consisting of a housing cover (8), a housing shell (9) and a housing base (10, 17), and electrical connections (11) for the multilayer actuator (1) being guided into the housing (23), **characterized in that** the housing (23) is hermetically sealed by means of welding, in particular laser welding, brazing with metal solder, soldering with glass solder or soft-soldering, the chamber (24) is partially filled or filled with a medium (21), the medium (21) absorbs and chemically converts water as it hardens, and the housing base (10, 17) consists of metal and the electrical connections (11) are guided into the interior of the housing (23) via a glass feed-through (12) or ceramic feed-through (14) in the housing base (10, 17) or the housing base (10, 17) consists of ceramic and comprises metallized openings into which the electrical connections are soldered.

2. Actuator module according to claim 1, **characterized in that** the medium (21) reactively consumes water.

3. Actuator module according to either claim 1 or claim 2, **characterized in that** the medium (21) contains polyurethane resin.

4. Actuator module according to any of the preceding claims, **characterized in that** the housing base has a metallized region on the outer circumference, via which region the housing base is connected to the housing shell in a hermetically sealed manner.

5. Actuator module according to any of the preceding claims, **characterized in that** the housing cover consists of ceramic and preferably has a metallized region on the outer circumference, via which region the housing cover is connected to the housing shell in a hermetically sealed manner.

6. Actuator module according to any of the preceding claims, **characterized in that** the housing shell consists entirely or in part of a metal bellows.

7. Actuator module according to any of the preceding claims, **characterized in that** the housing shell which consists entirely or in part of a metal bellows generates the required mechanical preloading for the multilayer actuator.

8. Actuator module according to any of the preceding claims, **characterized in that** the housing shell consists entirely or in part of ceramic and the electrical connections are arranged in the housing base and housing cover.

9. Actuator module according to any of the preceding claims, **characterized in that** the housing base and/or the housing cover consist of a flexible membrane.

10. Actuator module according to any of the preceding claims, **characterized in that** the housing base, the housing shell and the housing cover are connected in a hermetically sealed manner by means of welding, in particular laser welding, brazing with metal solder, soldering with glass solder or soft-soldering.

## Revendications

1. Module d'actionnement (22) comportant un actionneur multicouche (1) piézocéramique disposé dans un boîtier (23), le boîtier (23) étant hermétiquement fermé et un espace (24) étant disposé entre l'actionneur multicouche (1) et le boîtier (23), le boîtier (23) étant constitué d'un couvercle de boîtier (8), d'une enveloppe de boîtier (9) et d'un fond de boîtier (10, 17) et des connexions électriques (11) pour l'actionneur multicouche (1) étant guidées dans le boîtier (23), **caractérisé en ce que** le boîtier (23) est hermétiquement fermé par soudage, en particulier par soudage laser, par brasage fort avec brasure métallique, par brasage avec brasure de verre ou par brasage tendre, **en ce que** l'espace (24) est partiellement rempli ou rempli d'un milieu (21), **en ce que** le milieu (21) absorbe l'eau pendant qu'il durcit et se transforme chimiquement, et **en ce que** le fond de boîtier (10, 17) est en métal et les connexions électriques (11) sont guidées à l'intérieur du boîtier (23) par l'intermédiaire d'une traversée en verre (12) ou d'une traversée en céramique (14) dans le fond de boîtier (10, 17) ou le fond de boîtier (10, 17) est en céramique et présente des ouvertures métallisées dans lesquelles sont soudées les connexions électriques.

2. Module d'actionnement selon la revendication 1, **caractérisé en ce que** le milieu (21) consomme de l'eau de manière réactive.

3. Module d'actionnement selon la revendication 1 ou 2, **caractérisé en ce que** le milieu (21) contient de la résine polyuréthane.

4. Module d'actionnement selon l'une des revendications précédentes, **caractérisé en ce que** le fond de boîtier présente une zone métallisée sur le pourtour extérieur, par l'intermédiaire de laquelle s'effectue une liaison hermétiquement étanche du fond de boîtier avec l'enveloppe de boîtier.

5. Module d'actionnement selon l'une des revendications précédentes, **caractérisé en ce que** le couvercle de boîtier est en céramique et présente de préférence une zone métallisée sur le pourtour extérieur, par l'intermédiaire de laquelle s'effectue une liaison hermétiquement étanche du couvercle de boîtier avec l'enveloppe de boîtier.

6. Module d'actionnement selon l'une des revendications précédentes, **caractérisé en ce que** l'enveloppe de boîtier est constituée entièrement ou partiellement d'un soufflet métallique.

7. Module d'actionnement selon l'une des revendications précédentes, **caractérisé en ce que** l'enveloppe de boîtier, constituée entièrement ou partiellement d'un soufflet métallique, génère la précontrainte mécanique nécessaire pour l'actionneur multicouche.

8. Module d'actionnement selon l'une des revendications précédentes, **caractérisé en ce que** l'enveloppe de boîtier est entièrement ou partiellement en céramique et les connexions électriques sont disposées dans le fond de boîtier et le couvercle de boîtier.

9. Module d'actionnement selon l'une des revendications précédentes, **caractérisé en ce que** le fond de boîtier et/ou le couvercle de boîtier sont constitués d'une membrane souple.

10. Module d'actionnement selon l'une des revendications précédentes, **caractérisé en ce que** le fond de boîtier, l'enveloppe de boîtier et le couvercle de boîtier sont reliés de manière hermétiquement étanche par soudage, en particulier par soudage laser, par brasage fort avec brasure métallique, par brasage avec brasure de verre ou par brasage tendre.
